# FASCICULE DE BREVET EUROPEEN

(11) **EP 2 359 153 B1**
(45) Date de publication et mention de la délivrance du brevet: **16.10.2013**
(21) Numéro de dépôt: 09802177.7
(22) Date de dépôt: 15.12.2009
(51) Int. Cl.: G01R 31/04, G01R 31/28

(54) **DISPOSITIF DE TEST D'UN CIRCUIT ET PROCEDE DE MISE EN OEUVRE**
GERÄT UND VERFAHREN ZUR SCHALTUNGSPRÜFUNG
CIRCUIT TEST DEVICE AND PROCEDURE

(30) Priorité: 17.12.2008 FR 0858735
(43) Date de publication de la demande: 24.08.2011
(73) Titulaire: European Aeronautic Defence and Space Company EADS France, 75016 Paris (FR)
(72) Inventeur: MOREAU, Katell, 44000 Nantes (FR); GRIEU, Marc, F-94200 Ivry sur Seine (FR)
(74) Mandataire: Marconnet, Sébastien
(86) Numéro de dépôt international: PCT/FR2009/052538
(87) Numéro de publication internationale: WO 2010/076482

(56) Documents cités:
- US-A1- 2004 036 466
- US-A1- 2007 199 386
- US-B1- 6 564 986
- PRZEMYSLAW MATKOWSKI ET AL: "Application of FPGA units in combined temperature cycle and vibration reliability tests of lead-free interconnections" ELECTRONICS SYSTEMINTEGRATION TECHNOLOGY CONFERENCE, 2008. ESTC 2008. 2ND, IEEE, PISCATAWAY, NJ, USA, 1 septembre 2008 (2008-09-01), pages 1375-1380, XP031364687 ISBN: 978-1-4244-2813-7 cité dans la demande

## Description

La présente invention concerne un dispositif de test d'un circuit électronique et son procédé de mise en oeuvre. Elle a trait à un dispositif de détection de fissures dans des joints de brasure réalisant l'assemblage de composants électroniques sur un circuit imprimé. L'invention concerne également le procédé de fonctionnement de ce dispositif. L'invention a pour but de permettre à un utilisateur de qualifier un tel circuit, c'est à dire de détecter rapidement et simplement des fissures naissantes se trouvant dans des joints de brasure de composants électroniques assemblés sur un circuit imprimé.

Dans l'état de la technique, les composants électroniques peuvent subir des contraintes environnementales et mécaniques, constantes ou cycliques, très fortes, comme par exemple dans des moyens de transports du type avion, train ou bateau. Dans les moyens de transports précités, les températures peuvent varier de -55°C à 125°C, le ta ux d'humidité relative d'une armoire dans laquelle sont situés ces composants électroniques peut atteindre environ 80%.

Il est donc important, pour des questions de sécurité de fonctionnement, de vérifier que l'assemblage des composants électroniques assemblés sur un circuit imprimé supporte de telles contraintes. Pour cela, on utilise généralement des bancs de tests pour détecter d'éventuelles fissures naissantes au niveau des joints de brasure assurant la connexion électrique et la liaison mécanique entre le composant et le circuit imprimé..Ces bancs de test sont utilisés lors d'essais de vieillissement accéléré thermomécanique ou vibratoire. Des composants factices (c'est-à-dire seulement les boîtiers avec puces factices) sont utilisés pour réaliser les essais de vieillissement accéléré thermomécanique ou vibratoire car seuls les joints de brasure sont testés ici. On désigne par « daisy chaîne » l'association d'un certain nombre de joints de brasure, reliés électriquement entre eux, en série, d'un même composant,. L'ensemble forme une résistance électrique globale mesurable. L'utilisation des composants factices daisy chainés permet à l'utilisateur de focaliser son étude sur les défaillances intervenant au niveau des joints de brasure. Cette technique permet d'associer une mesure résistive à un état d'endommagement des joints brasés.

Pour qualifier un circuit, on mesure le temps de défaillance de ses joints de brasure et donc la durée de vie de son assemblage. Ensuite on en déduit une fiabilité de l'assemblage résultant d'une étude statistique. Autrement dit, il est nécessaire de tester de nombreux composants d'un même type pour avoir des résultats significatifs. Il est donc important de disposer d'un dispositif comportant un nombre important de voies de mesure pour pouvoir suivre, simultanément, un grand nombre de composants.

Il existe actuellement différents dispositifs permettant d'effectuer ces tests. Un exemple d'un tel dispositif est décrit dans le document « ROHS/ELV recycling constraints : a lead Free electronics qualification procedure for automotive and industrial quality and reliability » (Philippe Prieur et al., 4th International Electronics Conférence, 26 avril 2006, Malmo, Suède). Ce document présente un banc de test réalisant un suivi électrique en parallèle des différents composants testés.

Un autre exemple de dispositif est décrit dans le document « Application of FPGA units in combined temperature cycle and vibration reliability tests of lead free interconnections » (Przemyslaw Matkowski et al, 2nd Electronics Systemintegration Technology Conference, IEEE, Piscataway, NJ, Etats-Unis, 1er septembre 2008, pages 1375-1380). Ce document présente un dispositif d'acquisition, qui surveille un ensemble de voies en parallèle.

L'art antérieur connaît également, par la demande de brevet américain N° US 2007/199386, un dispositif de mesure de la résistance.

Toutefois, avec les dispositifs présentés dans l'art antérieur, on ne détecte une fissure ou une défaillance que lorsqu'il y a une rupture totale du joint de brasure. De plus, il est nécessaire de dupliquer le dispositif de test en entier, pour chaque carte électronique testée et de changer le dispositif pour chaque essai réalisé. En effet, le dispositif de test est embarqué sur la carte électronique à tester et subit les mêmes contraintes thermomécaniques ou vibratoires que les composants électroniques sous test. Cette duplication provoque un surcoût assez important, du fait des risques de mesures non pertinentes et de la dégradation précoce du circuit réalisant les mesures.

En outre, un autre inconvénient de l'art antérieur est la détection tardive d'évènements de changement d'état, ou pics (forte variation de la valeur résistive sur un temps très court) de la résistance électrique d'un certain nombre de joints de brasure reliés électriquement entre eux, en série, d'un même composant (une daisy chaîne) De plus, de tels dispositifs de l'art antérieur nécessitent beaucoup de ressource en termes d'énergie électrique pour alimenter plusieurs circuits logiques programmables en même temps.

Les dispositifs connus appliquent la norme IPC-SM-785 ou ne détectent que les premiers pics de résistance électrique aussi appelé événement. Or cette norme, toute seule est dans certains cas, mal adaptée à la détection des défaillances car elle retient comme critère de défaillance des successions temporelles de pics répondant à un gabarit temporel et résistif donné. Or ce gabarit ou protocole peut conduire à de mauvaises conclusions. Typiquement, une mauvaise conclusion est de ne pas détecter la rupture d'un circuit testé car le gabarit précédant est strictement appliqué. Il en résulte qu'un circuit sera supposé détruit au bout de N cycles, alors qu'il va dans la réalité faire défaut bien avant. Pour résoudre ce problème, dans l'invention, plutôt que de suivre impérativement les critères (gabarits temporels et/ou résistifs ou protocoles) de la norme, on prévoit de modifier ces critères de préférence d'une manière quantifiée, de façon à s'adapter aux différents types d'essais et mécanismes de dégradation des joints brasés associés. En définitive, avec l'invention, chaque critère programmé est adapté aux essais à réaliser.

L'invention résout ainsi ce problème en proposant un dispositif de détection de fissures ou défaillances naissantes dans les joints de brasure de composants électroniques assemblés sur un circuit imprimé, selon un critère choisi et défini par l'utilisateur.

L'invention prévoit, la surveillance simultanée d'un grand nombre de composants pour appliquer de manière automatique un critère de détection prédéterminé par un utilisateur caractérisant la défaillance d'un joint brasé. L'invention permet d'obtenir directement des résultats de mesures effectuées sur les composants, évitant ainsi tout traitement à postériori.

L'invention a donc pour objet, un dispositif de test d'un circuit formé d'un circuit imprimé sur lequel sont assemblés des composants de préférence factices, par des joints de brasure, comportant,
- une enceinte pour soumettre le circuit à un historique de contraintes thermomécaniques et/ou vibratoires.
- une partie matérielle comportant des ponts de résistances électriques afin de mesurer la résistance électrique globale de plusieurs joints de brasure reliés électriquement entre eux, en série.
- une partie logicielle comportant des moyens pour fixer un critère de détection représentatif de la dégradation d'un ou plusieurs joints de brasure réalisant l'assemblage d'un composant électronique sur un circuit imprimé, et pour visualiser les résultats du test,

- une interface d'entrée/sortie pour convertir chaque mesure de résistance électrique des chaînes de joints de brasure testées, en une donnée exploitable par la partie logicielle, caractérisé en ce qu'il comporte,
- des moyens de réglage pour modifier un critère de détection de la dégradation des joints brasés.

L'invention comporte en outre l'une des caractéristiques suivantes :
- les moyens de réglage permettent de modifier un seuil de détection d'un niveau de résistance électrique du circuit sous test ;
- les moyens de réglage comportent un potentiomètre pour fixer le seuil de détection du niveau de la résistance électrique du composant du circuit sous test ;
- les moyens de réglage permettent de modifier la durée des pics de résistance électrique à détecter ;
- les moyens de réglage comportent un potentiomètre pour fixer la durée des pics de résistance électrique à détecter ;
- les moyens de réglage permettent de modifier un nombre de changements d'état du circuit sous test à détecter pour la validation du critère initialement choisi par l'utilisateur ;- les moyens de réglage comportent un sélecteur pour déterminer un nombre de pics ou événements à détecter pour l'application du critère de détection représentatif de la dégradation d'un ou plusieurs joints brasés ;
- les moyens de réglage permettent de modifier un intervalle de temps entre deux détections de changement d'état du circuit sous test, à l'aide d'un potentiomètre ;
- les moyens de réglage comportent des potentiomètres pour déterminer un intervalle de temps après un pic pour la détection d'un pic suivant ;- l'intervalle de temps minimum entre deux détections de changement d'état de composant est de 250ns ;
- la durée des pics de résistance électrique à détecter est réglable entre 250ns et 1µs;
- la durée entre le début du test et le premier pic de résistance électrique détecté paramétrée pour le critère souhaité par l'utilisateur est réglable ;
- la partie logicielle comporte des moyens d'enregistrement et de traitement en temps réel des résultats ;
- la partie logicielle comporte des moyens d'enregistrement et de traitement en différé des résultats ;
- la partie matérielle est intégrée à une carte électronique extérieure à l'enceinte.

Elle concerne également, un procédé de mise en oeuvre d'un dispositif de test tel que décrit précédemment dans lequel :
- on initialise des paramètres de détection de dégradation des joints de brasure,
- on détecte et enregistre des changements d'état de la résistance électrique d'un ou plusieurs joints de brasure à tester, qui se caractérise par des pics de résistance électrique d'une durée comprise entre 250ns et 1µs,
- on transmet les changements d'état à la partie logicielle pour être analysés,
- on détermine si une fissure a été détectée sur l'une des chaines de joints de brasure testées, puis l'on enregistre l'emplacement sur le circuit du composant présentant cette fissure ou défaillance électrique et la chaine de joints brasés associée.

L'invention sera mieux comprise à la lecture de la description qui suit et à l'examen des figures qui l'accompagnent. Celles-ci ne sont présentées qu'à titre illustratif mais nullement limitatif de l'invention. Les figures montrent :
Figure 1 : une représentation schématique du dispositif de l'invention ;
Figure 2 : un diagramme fonctionnel du procédé selon l'invention ;

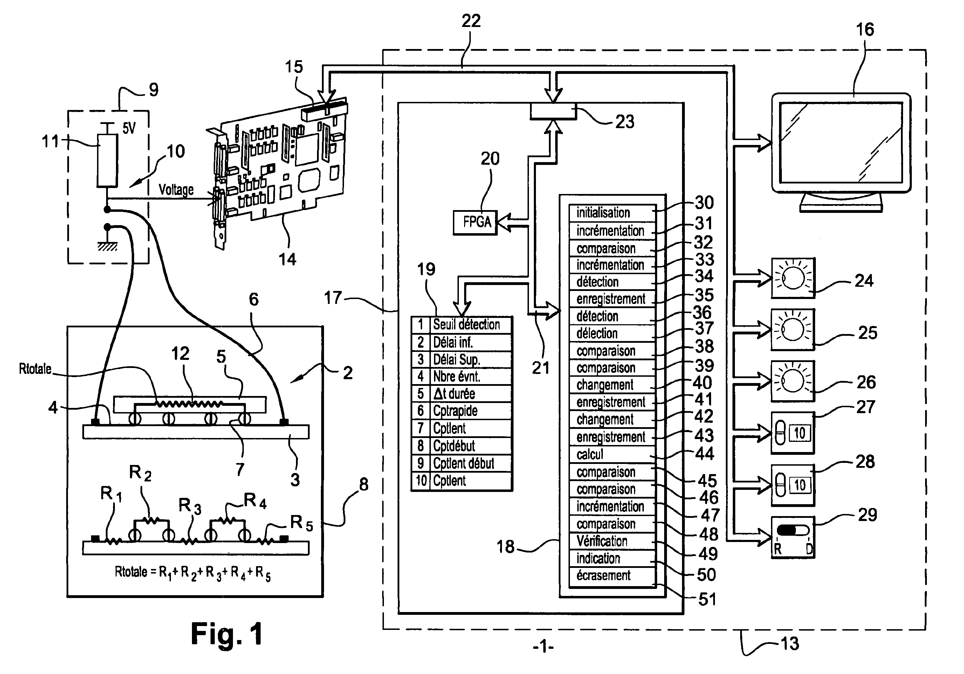

La figure 1 est une représentation schématique montrant un dispositif 1 de test d'un circuit électronique 2 selon l'invention. Un circuit électronique 2 est formé d'un circuit imprimé 3, ,doublé extérieurement d'une fine couche de cuivre 4, réalisant les pistes conductrices du système électrique global, sur laquelle sont assemblés des composants électroniques 5. Pour solidariser le composant 5 au circuit imprimé 3 et notamment pour assurer une continuité électrique entre des connexions du composant 5 et des pistes conductrices réalisées dans la couche de cuivre 4 du circuit imprimé 3, des joints brasés 7 se présentant chacun sous la forme d'une bille de soudure (par exemple) sont réalisés.

Les joints de brasure 7 subissent une fatigue mécanique faisant apparaître des fissures. Cette fatigue mécanique des joints de brasure 7 découle des contraintes thermomécaniques et / ou vibratoires subies par le composant électronique 5 et le circuit imprimé 3, notamment pour des circuits 2 placés dans des moyens de transports tels que des avions, des trains ou des bateaux. Or, ces moyens de transport nécessitent, du fait qu'ils se trouvent dans la catégorie des moyens de transport de masse, d'une sécurité de fonctionnement optimale.

Pour résoudre ce problème, l'invention se propose de mettre en oeuvre un dispositif 1 de test du circuit 2 permettant la détection des fissures ou défaillances éventuelles des joints de brasure 7.

Ce dispositif 1 permet d'évaluer la fiabilité des assemblages des différents composants électroniques 5. Il comporte pour cela une enceinte climatique 8 et/ ou un pot vibrant, afin de soumettre le circuit 2 à un historique de contraintes thermomécaniques et / ou vibratoires. Le dispositif de test 1 est de préférence placé dans une cage de Faraday pour éviter toutes interférences électromagnétiques avec les mesures. Cet historique de contraintes est prédéterminé par un utilisateur. Ces contraintes peuvent être thermomécaniques et / ou vibratoires. Cette enceinte climatique 8 permet, aux moyens des contraintes prédéterminées, de soumettre le circuit 2 à des essais de vieillissement accéléré.

Le dispositif 1 comporte une partie matérielle 9 formée par un pont de résistances électriques 10. Ce pont de résistances électriques 10 comporte au moins une résistance électrique de référence 11 qui a une valeur considérée comme connue et une autre résistance électrique 12, correspondant à une valeur d'une résistance globale formée par la daisy chaine testée. Cette daisy chaine pouvant comportée elle-même plusieurs joints brasés d'un même composant électronique..La valeur de la résistance électrique 12 du composant électronique sous test est considérée comme inconnue mais très faible. La résistance électrique de référence 11 est de l'ordre de 500 Ω ou d'une valeur très supérieure à la résistance électrique 12 du composant 5 sous test. Le pont de résistance électrique 10 permet de mesurer la résistance électrique d'un certain nombre de joints de brasure reliés électriquement entre eux, en série de chaque composant 5. Dans l'invention, la résistance électrique 12 est formée par les différents joints de brasure, les résistances électriques du circuit testé et les résistances électriques des pistes du circuit imprimé. L'ensemble est connecté aux connexions 6.

Le dispositif 1 comporte en outre une partie logicielle 13. Cette partie logicielle 13 comporte des moyens permettant d'imposer un critère de détection représentatif de la dégradation des joints de brasure 7. En effet, l'intérêt du dispositif 1 de l'invention est de détecter les fissures ou défaillances naissantes, visibles ou non visibles, dans les joints de brasure 7. Pour cela, le dispositif 1 dispose de moyen permettant d'appliquer notamment des critères IPC, édités par l'Institut for Interconnecting and Packaging Electronic Circuits, reconnues à l'échelle mondiale en matière d'homologation. La détection de fissures dans les joints de brasure 7 est régie, par exemple, par la norme IPC-SM-785. Ce critère définit de manière électrique l'apparition d'une fissure dans un joint de brasure 7 soumis à des essais de vieillissement accéléré, environnementaux et ou mécaniques. Ce critère considère qu'il y a une amorce de fissure lorsqu'on détecte 10 pics successifs pour une résistance électrique 12 du composant 5 ayant pour caractéristique une valeur de résistance électrique comprise entre 300 et 500 Ω et une durée comprise entre 500 ns et 1 µs. Il est également nécessaire que cet ensemble de dix pics successifs se produise dans un intervalle de temps inférieur à 10% du temps écoulé entre le début du test et le dixième pic détecté.

L'acquisition et le codage des données analogiques mesurées avec la partie matérielle 9 et l'analyse des données numériques par la partie logicielle 13 sont effectuées par une carte 14 extérieure à l'enceinte. Par exemple cette carte 14 comporte 160 entrées pour tester 160 circuits tels que 2 simultanément. Cette carte 14 permet de surveiller simultanément plusieurs composants comportant chacun un ou plusieurs circuits identiques au circuit 2, pour détecter les pics de résistance électrique. Les 160 entrées sont analysées en parallèle : chacune est en relation avec un pont de résistance électrique 10 de mesure. Ces ponts 10 de mesure délivrent chacun un échelon de tension passant de 0 à 1 (0-5 volts) lorsqu'une fissure s'ouvre et un échelon inverse lorsqu'elle se referme. Cette carte 14 ne supporte pas les contraintes thermomécaniques et / ou vibratoires des circuits 2 situés dans l'enceinte 8. La carte 14 peut comporter les ponts de résistance électrique 10, et dans ce cas être reliée directement aux connexions 6.

Lorsqu'un grand nombre de composants, ont été soumis au test, le dispositif 1 comporte des moyens 16 de visualisation des résultats des mesures effectuées sur chaque composant. Ces résultats permettent de déterminer des statistiques de durée de vie des assemblages réalisés par des joints de brasure 7, afin de qualifier les assemblages des composants 5 sur les circuits imprimés 3.

Pour assurer les différentes actions de la partie logicielle 13, cette dernière est formée par un système informatique 17. Ce système informatique 17 comporte un FPGA (Field Programmable Grid Array) pour réaliser l'analyse in situ des mesures des 160 voies (15) et les afficher sur un moyen de visualisation (16), par l'intermédiaire d'un autre bus de communication 22. Le système informatique 17 comporte une interface d'entrées/sortie 23, permettant de relier les bus 21 et 22. Le bus de communication 21 est également relié par l'intermédiaire du bus de communication 22 à des moyens de réglage 24, 25, 26, 27, 28, 29 afin que l'utilisateur puisse modifier le critère de détection de la dégradation.

Les actions menées par le système informatique 17 sont ordonnées par le FPGA 20. Le FPGA 20 produit, en réponse aux codes d'instructions enregistrés dans la mémoire programme 18 des ordres destinés à la carte 14 et, affiche les résultats grâce, aux moyens 16 de visualisation.

La mémoire programme comporte à cet effet plusieurs zones de programme 30 à 51, correspondant respectivement à une suite d'opérations.

Une opération 30 correspond à une initialisation des paramètres de détection des pics de résistance électriques ou changement d'état. Une opération 31 correspond à l'incrémentation d'un compteur rapide. Une opération 32 correspond à la comparaison de la valeur du compteur rapide avec une valeur maximum du compteur rapide. Une opération 33 correspond à l'incrémentation d'un compteur lent. Les opérations 31, 32 et 33 permettent de déterminer avec précision le temps de détection d'un changement d'état. Une opération 34 correspond à la détection d'un changement d'état de 0 à 1. Une opération 35 correspond à un enregistrement de l'état et des compteurs, lorsqu'un changement d'état est détecté. Une opération 36 correspond à une détection d'un changement d'état de 1 à 0. Une opération 37 correspond à déterminer si l'état est à 0 ou à 1. Des opérations 38 et 39 correspondent à une comparaison de l'état actuel avec l'état antérieur. Une opération 40 correspond à un changement d'état de 0 à 1. Une opération 42 correspond à un changement d'état de 1 à 0. Des opérations 41 et 43 correspondent à des enregistrements des compteurs dans des variables de calcul d'une durée d'un pic. Une opération 44 correspond au calcul de la durée de détection d'un pic de résistance électrique. Une opération 45 correspond à une comparaison de la durée calculée à l'opération 44, avec une valeur inférieure de durée prédéterminée lors de l'opération 30 d'initialisation. Une opération 46 correspond à une comparaison de la durée calculée à l'opération 44, avec une valeur supérieure de durée, prédéterminée lors de l'opération 30 d'initialisation. Une opération 47 correspond à une incrémentation du nombre de pics détectés, puis à l'enregistrement de la durée calculée, du compteur de début du pic, et du numéro de la voie de mesure où le pic a été détecté. Une opération 48 correspond à une comparaison du nombre de pic avec le nombre de pics maximum prédéterminé lors de l'opération 30 d'initialisation. Une opération 49 correspond à une vérification du critère. Ce critère étant la détection ou mesure d'un certains nombre de pics successifs dans un temps inférieur à un certains pourcentage du temps séparant le début du test et le premier pic détecté. Si la norme IPC-SM-785 est utilisée comme critère, 10 pics sont à détecter sur un temps inférieur à 10% du temps écouler entre le début de l'essai et le premier pic détecté. Une opération 50 correspond à une indication qu'une défaillance ou une fissure a été détectée si le test précédant est satisfait, puis à l'enregistrement du numéro de la voie de mesure où se trouve la fissure, ainsi que la valeur du compteur du début du premier pic. Une opération 51 correspond à un écrasement de la valeur de la durée du pic antérieur avec la valeur du pic actuel si le test 49 n'est pas satisfait.

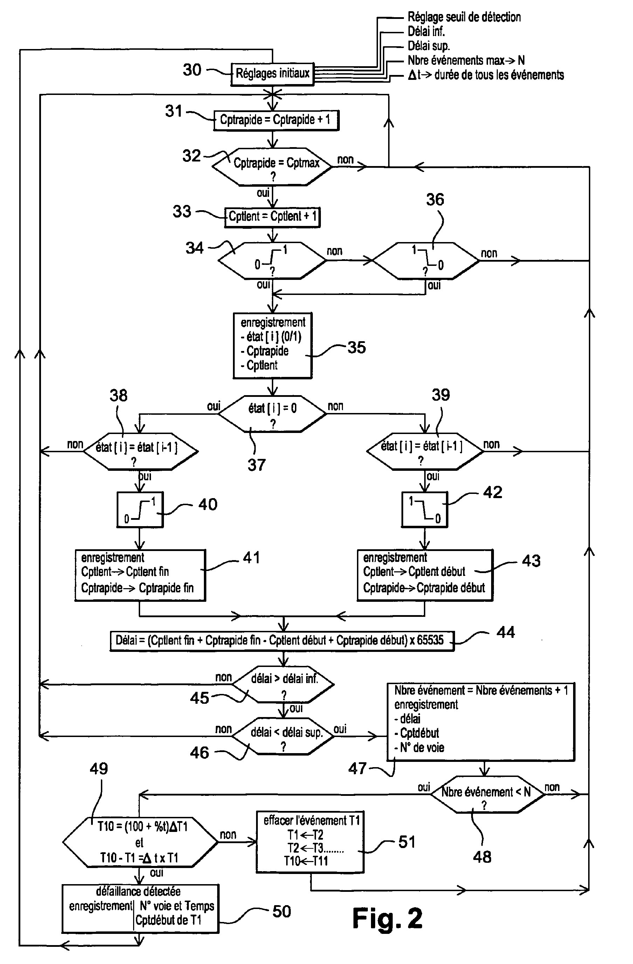

La figure 2 est un exemple d'un diagramme fonctionnel du procédé selon l'invention. Un programme général comportant tous les sous programmes 30 à 51 organise la succession de ces opérations selon le mode suivant. Ce diagramme montre l'opération préliminaire 30 dans laquelle on effectue une initialisation des paramètres de détection des pics de résistance ou changement d'état, comme le réglage du seuil de détection des pics, la valeur inférieure et la valeur supérieure de la durée de détection d'un pic, le nombre de pics maximum à détecter, la durée de détection de l'ensemble des pics, le choix d'un enregistrement avec une analyse en temps réel ou différée. Ce paramétrage est effectué respectivement par des moyens de réglage 24, 25, 26, 27, 28, 29. Dans cette opération tous les compteurs sont initialisés. Lorsque les paramètres sont initialisés, alors on peut effectuer l'opération 31.

Lors de l'opération 31, on effectue une incrémentation d'un compteur Cptrapide. Lorsque le compteur Cptrapide est incrémenté, alors on effectue l'opération 32.

Lors de l'opération 32, on effectue une comparaison de la valeur du compteur Cptrapide avec une valeur maximum du compteur Cptmax. Cette valeur Cptmax peut par exemple être 60. Lorsque la valeur Cptrapide atteint la valeur Cptmax, alors on effectue l'opération 33, sinon on réitère l'opération 31.

Lors de l'opération 33, on effectue une incrémentation d'un compteur Cptlent. Lorsque le compteur Cptlent est incrémenté, alors on effectue l'opération 34.

Lors de l'opération 34, on détermine si un changement d'état de 0 à 1 du pont 10 de résistances a eu lieu. Lorsqu'un changement d'état de 0 à 1 a eu lieu, alors on effectue l'opération 35, sinon on effectue l'opération 36.

Lors de l'opération 35, on effectue un enregistrement du nouvel état, ainsi que les valeurs des compteurs Cptrapide et Cptlent. Lorsque l'enregistrement du nouvel état et des compteurs est effectué, alors on effectue l'opération 37.

Lors de l'opération 36, on détermine si un changement d'état de 1 à 0 a eu lieu. Lorsqu'un changement d'état de 1 à 0 a eu lieu, alors on effectue l'opération 36, sinon on réitère l'opération 31 ou 32 ou 33 ou 34.

Lors de l'opération 37, on détermine si le nouvel état est à 0. Lorsque le nouvel état est à 0, on effectue l'opération 38, sinon on effectue l'opération 39.

Lors de l'opération 38, on effectue une comparaison du nouvel état avec l'état antérieur. Lorsque le nouvel état et l'état antérieur sont identiques, alors on effectue l'opération 40, sinon on réitère l'opération 31 ou 32 ou 33 ou 34 ou 35 ou 36 ou 37.

Lors de l'opération 40, on effectue un changement d'état de 0 à 1. Lorsque le changement d'état de 0 à 1 a eu lieu, on effectue l'opération 41.

Lors de l'opération 41, on effectue un enregistrement de la valeur du compteur Cptlent dans une variable Cptlentdébut, et un enregistrement de la valeur du compteur Cptrapide dans une variable Cptrapidedébut. Lorsque l'enregistrement des compteurs est effectué, alors on effectue l'opération 44.

Lors de l'opération 39, on effectue une comparaison du nouvel état avec l'état antérieur. Lorsque le nouvel état et l'état antérieur sont identiques, alors on effectue l'opération 42, sinon on réitère l'opération 31 ou 32 ou 33 ou 34 ou 35 ou 36 ou 37.

Lors de l'opération 42, on effectue un changement d'état de 1 à 0. Lorsque le changement d'état de 1 à 0 a eu lieu, on effectue l'opération 43.

Lors de l'opération 43, on effectue un enregistrement de la valeur du compteur Cptlent dans une variable Cptlentfin, et un enregistrement de la valeur du compteur Cptrapide dans une variable Cptrapidefin. Lorsque l'enregistrement des compteurs est effectué, alors on effectue l'opération 44.

Lors de l'opération 44, on effectue un calcul de la durée de détection d'un pic, correspondant à la différence entre la somme des valeurs des variables Cptlentfin avec Cptrapidefin, et la somme des valeurs des variables Cptlentdébut avec Cptrapidedébut. Cette différence étant ramenée en unité de la nanoseconde. Lorsque le calcul de la durée de détection d'un pic est effectué, on effectue l'opération 45.

Lors de l'opération 45, on effectue une comparaison de la durée calculée avec une valeur inférieure de la durée de détection d'un pic prédéterminée lors de l'opération 30. Lorsque la durée calculée est supérieure à la durée inférieure prédéterminée, alors on effectue l'opération 46, sinon on réitère l'opération 31.

Lors de l'opération 46, on effectue une comparaison de la durée calculée avec une valeur supérieure de la durée de détection d'un pic, prédéterminé lors de l'opération 30. Lorsque la durée calculée est inférieure à la durée supérieure prédéterminée, alors on effectue l'opération 47, sinon on réitère l'opération 31.

Lors de l'opération 47, on effectue une incrémentation du nombre de pics détectés, puis on enregistre la durée calculée, le compteur de début du pic détecté, et le numéro de la voie de mesure où le pic a été détecté. Lorsque cette incrémentation a été effectuée, alors on effectue l'opération 48.

Lors de l'opération 48, on effectue une comparaison du nombre de pics avec le nombre de pics maximum prédéterminé à l'opération 30. Lorsque le nombre de pics détectés est inférieur au nombre de pic maximum prédéterminé, alors on effectue l'opération 49, sinon on réitère l'opération 31.

Lors de l'opération 49, on effectue une vérification que l'on a bien détecté dix pics successifs dans un gabarit temporel prédéfini par l'utilisateur. Lorsque dix pics successifs ont été détectés, alors on effectue l'opération 50, sinon on effectue l'opération 51.

Lors de l'opération 50, on effectue une indication qu'une défaillance ou fissure a été détectée, puis l'on enregistre le numéro de la voie de mesure où la défaillance a été détectée, la durée de détection des dix pics, du compteur de début du premier pic. Lorsque l'indication de la défaillance a été effectuée, alors on réitère l'opération 30, sinon on effectue l'opération 51.

Lors de l'opération 51, on effectue un écrasement de la durée de détection du pic antérieur avec la durée de détection du pic actuel. Lorsque cet écrasement est effectué, on réitère l'opération 31.

## Revendications

1. Dispositif (1) de test d'un circuit (2) formé d'un circuit imprimé (3) sur lequel sont assemblés des composants (5), de préférence factices, par des joints de brasure (7), comportant,
- une enceinte (8) pour soumettre le circuit (2) à un historique de contraintes thermomécaniques et/ou vibratoires,
- une partie matérielle (9) comportant des ponts (10) de résistances électriques (11, 12), afin de mesurer la résistance électrique (12) globale de plusieurs joints de brasure reliés électriquement entre eux, en série,
- une partie logicielle (13) comportant des moyens (16-23) pour fixer un critère de détection représentatif de la dégradation d'un ou plusieurs joints de brasure réalisant l'assemblage d'un composant (5) électronique sur un circuit imprimé, et pour visualiser les résultats du test,
- une interface d'entrée/sortie (14) pour convertir chaque mesure de résistance électrique (12) des chaînes de joints de brasure (7) testées, en une donnée exploitable par la partie logicielle (13),
- des moyens de réglage (24-29) pour modifier un critère de détection de la dégradation des joints brasés,
**caractérisé en ce qu'**il comporte :
- des moyens pour initialiser des paramètres de détection de dégradation des joints de brasure,
- des moyens pour détecter et enregistrer des changements d'état de la résistance électrique d'un ou plusieurs joints de brasure à tester, qui se **caractérise par** des pics de résistance électrique d'une durée comprise entre 250 ns et 1 µs,
- des moyens pour transmettre les changements d'état à la partie logicielle pour être analysés,
- des moyens pour déterminer si une fissure a été détectée sur l'une des chaines de joints de brasure testées et des moyens pour enregistrer l'emplacement sur le circuit du composant présentant cette fissure et de la chaîne de joints brasés associée.

2. Dispositif selon la revendication 1, **caractérisé en ce que** les moyens de réglage (24-29) permettent de modifier un seuil de détection d'un niveau de résistance électrique du circuit sous test.

3. Dispositif selon la revendication 2, **caractérisé en ce que** les moyens de réglage (24-29) comportent un potentiomètre (24) pour fixer le seuil de détection du niveau de la résistance électrique du composant (5) du circuit (2) sous test.

4. Dispositif selon l'une des revendications 1 à 3, **caractérisé en ce que** les moyens de réglage (24-29) permettent de modifier un nombre de changement d'état du circuit (2) sous test à détecter pour la validation du critère initialement choisi par un utilisateur.

5. Dispositif selon la revendication 4, **caractérisé en ce que** les moyens de réglage (24-29) comportent un sélecteur (27) pour déterminer un nombre de pics à détecter pour l'application du critère de détection.

6. Dispositif selon l'une des revendications 1 à 5, **caractérisé en ce que** les moyens de réglage (24-29) permettent de modifier un intervalle de temps entre deux détections de changement d'état du circuit (2) sous test.

7. Dispositif selon la revendication 6, **caractérisé en ce que** les moyens de réglage (24-29) comportent des potentiomètres (25, 26) pour déterminer un intervalle de temps après un pic pour la détection d'un pic suivant.

8. Dispositif selon la revendication 6 ou 7, **caractérisé en ce que** l'intervalle de temps minimum entre deux détections de changement d'état de composant (5) est de 250 ns.

9. Dispositif selon la revendication 1 à 8, **caractérisé en ce que** la durée des pics de résistance électrique à détecter est réglable entre 250 ns et 1µs.

10. Dispositif selon la revendication 9, **caractérisé en ce que** la durée entre le début du test et le premier pic de résistance électrique détecté paramétrée pour le critère souhaité par l'utilisateur est réglable

11. Dispositif selon l'une des revendications 1 à 10, **caractérisé en ce que** la partie logicielle (13) comporte des moyens (29) d'enregistrement et de traitement en temps réel des résultats.

12. Dispositif selon l'une des revendications 1 à 11, **caractérisé en ce que** la partie matérielle (9) est intégrée à une carte extérieure à l'enceinte (8).

13. Procédé de mise en oeuvre d'un dispositif (1) de test d'un circuit (2) formé d'un circuit imprimé (3) sur lequel sont assemblés des composants électroniques (4) de préférence factices, par des joints de brasure selon l'une quelconque des revendications 1 à 12, **caractérisé en ce qu'**il comporte les opérations suivantes :
- on initialise des paramètres de détection de dégradation des joints de brasure,
- on détecte et enregistre des changements d'état de la résistance électrique d'un ou plusieurs joints de brasure à tester, qui se **caractérise par** des pics de résistance électrique d'une durée comprise entre 250 ns et 1 µs,
- on transmet les changements d'état à la partie logicielle pour être analysés,
- on détermine si une fissure a été détectée sur l'une des chaines de joints de brasure testées puis l'on enregistre l'emplacement sur le circuit du composant présentant cette fissure et de la chaîne de joints brasés associée.

## Patentansprüche

1. Testgerät (1) für einen Schaltkreis (2) der aus einer Leiterplatte (3) besteht, auf der die vorzugsweise nachgemachten Bauteile (5) durch Lötstellen (7) zusammengefügt sind, mit
- einem Gehäuse (8), um den Schaltkreis (2) einer Historie von thermomechanischen und/oder schwingungstechnischen Belastungen auszusetzen,
- einem Hardware-Abschnitt (9) mit elektrischen Brücken (10) elektrischer Widerstände (11, 12) zum Messen des globalen elektrischen Widerstandes (12) mehrerer Lötstellen, die elektrisch miteinander in Reihe geschaltet sind,
- einem Software-Abschnitt (13) mit Vorrichtungen (16-23) zum Festlegen eines repräsentativen Erfassungskriteriums für die Beschädigung einer oder mehrerer Lötstellen zum Zusammenfügen eines elektronischen Bauteils (5) auf einer Leiterplatte, und zum Anzeigen der Testergebnisse,
- einer E/A Schnittstelle (14) zum Umwandeln jeder Messung des elektrischen Widerstandes (12) der getesteten Lötstellenketten (7) in eine Größe, die vom Software-Abschnitt (13) verarbeitet werden kann,
- Einstellvorrichtungen (24-29) zum Verändern eines Erfassungskriteriums für die Beschädigung der Lötstellen,
**dadurch gekennzeichnet, dass** es folgendes enthält:
- Vorrichtungen zum Zurücksetzen der Erfassungsparameter für die Beschädigung der Lötstellen,
- Vorrichtungen zum Erfassen und Speichern von Zustandsänderungen des elektrischen Widerstands einer oder mehrerer zu testender Lötstellen, **gekennzeichnet durch** elektrische Widerstandsspitzen innerhalb eines Zeitraums zwischen 250 ns und 1 µs,
- Vorrichtungen zum Übertragen der Zustandsänderungen zum Software-Abschnitt zwecks Analyse,
- Vorrichtungen zum Bestimmen, ob an einer der getesteten Lötstellenketten ein Riss entdeckt wurde, und Vorrichtungen zum Aufzeichnen der Stelle auf dem Schaltkreis des Bauteils mit diesem Riss, sowie der zugehörigen Lötstellenkette.

2. Gerät nach Anspruch 1, **dadurch gekennzeichnet, dass** anhand der Einstellvorrichtungen (24-29) ein Grenzwert zur Erfassung eines elektrischen Widerstandsniveaus des getesteten Schaltkreises verändert werden kann.

3. Gerät nach Anspruch 2, **dadurch gekennzeichnet, dass** die Einstellvorrichtungen (24-29) ein Potentiometer (24) zur Festlegung des Grenzwerts zur Erfassung eines elektrischen Widerstandsniveaus des Bauteils (5) des getesteten Schaltkreises (2) enthält.

4. Gerät nach einem der Ansprüche 1 bis 3, **dadurch gekennzeichnet, dass** anhand der Einstellvorrichtungen (24-29) eine Anzahl an Zustandsänderungen des getesteten Schaltkreises (2) verändert werden kann, die es zu erfassen gilt, um das ursprünglich von einem Benutzer ausgewählte Kriterium zu bestätigen.

5. Gerät nach Anspruch 4, **dadurch gekennzeichnet, dass** die Einstellvorrichtungen (24-29) einen Wahlschalter (27) zur Festlegung einer Anzahl von zu erfassenden Spitzen enthält, die es zur Anwendung des Erfassungskriteriums zu erfassen gilt.

6. Gerät nach einem der Ansprüche 1 bis 5, **dadurch gekennzeichnet, dass** anhand der Einstellvorrichtungen (24-29) ein Zeitintervall zwischen zwei Erfassungen einer Zustandsänderung des getesteten Schaltkreises (2) verändert werden kann.

7. Gerät nach Anspruch 6, **dadurch gekennzeichnet, dass** die Einstellvorrichtungen (24-29) Potentiometer (25, 26) zur Bestimmung eines Zeitintervalls nach einer Spitze enthalten, um die folgende Spitze zu erfassen.

8. Gerät nach Anspruch 6 oder 7, **dadurch gekennzeichnet, dass** kleinste Zeitintervall zwischen zwei Erfassungen der Zustandsänderung des Bauteils (5) bei 250 ns liegt.

9. Gerät nach Anspruch 1 bis 8, **dadurch gekennzeichnet, dass** die Dauer der zu erfassenden elektrischen Widerstandsspitzen zwischen 250 ns und 1 µs eingestellt werden kann.

10. Gerät nach Anspruch 9, **dadurch gekennzeichnet, dass** die für das gewünschte Kriterium vom Benutzer parametrierte Dauer zwischen dem Beginn des Tests und der ersten erfassten elektrischen Widerstandsspitze einstellbar ist.

11. Gerät nach einem der Ansprüche 1 bis 10, **dadurch gekennzeichnet, dass** der Software-Abschnitt (13) Vorrichtungen (29) zum Aufzeichnen und zur Verarbeitung der Ergebnisse in Echtzeit enthält.

12. Gerät nach einem der Ansprüche 1 bis 11, **dadurch gekennzeichnet, dass** sich der Hardware-Abschnitt (9) auf einer Karte befindet, die nicht zum Gehäuse (8) gehört.

13. Verfahren zur Anwendung eines Testgeräts (1) für einen Schaltkreis (2) der aus einer Leiterplatte (3) besteht, auf der die vorzugsweise nachgemachten Bauteile (4) durch Lötstellen verbaut sind, nach irgendeinem der Ansprüche 1 bis 12, **dadurch gekennzeichnet, dass** es die folgenden Vorgänge enthält:
- man setzt die Parameter zur Erfassung der Beschädigung der Lötstellen zurück,
- man erfasst und speichert die Zustandsänderungen des elektrischen Widerstands einer oder mehrerer zu testender Lötstellen, **gekennzeichnet durch** elektrische Widerstandsspitzen innerhalb eines Zeitraums zwischen 250 ns und 1 µs,
- man überträgt die Zustandsänderungen zum Software-Abschnitt zwecks Analyse,
- man bestimmt, ob an einer der getesteten Lötstellenketten ein Riss entdeckt wurde, und zeichnet die Stelle auf dem Schaltkreis des Bauteils mit diesem Riss, sowie der zugehörigen Lötstellenkette auf.

## Claims

1. A device (1) for testing a circuit (2) made up of a printed circuit board (3) on which components (5), preferably dummy components, are assembled by means of solder connections (7), comprising
- an enclosure (8) for subjecting the circuit (2) to a schedule of thermomechanical and/or vibration stresses,
- a hardware portion (9) comprising bridges (10) of electrical resistors (11, 12) in order to measure the overall electrical resistance (12) of multiple solder connections that are electrically interconnected, each one to the next,
- a software portion (13) comprising means (16-23) for setting a detection criterion representing damage to one or more solder connections that make up the assembly of an electronic component (5) on a printed circuit board, and for displaying the results of the test,
- an input/output interface (14) for converting each electrical resistor (12) measurement of the tested chains of solder connections (7) into data that can be used by the software portion (13),
- adjustment means (24-29) for modifying a criterion for detecting damage to the soldered connections,
**characterised in that** it includes:
- means for initialising detection parameters of damage of soldered connections,
- means for detecting and recording changes in state of electrical resistance of one or more soldered connections to test, which are **characterised by** peaks of electrical resistance of a comprised duration between 250 ns and 1 µs,
- means for transmitting the changes of state to the software portion to be analysed,
- means for determining if a fracture has been detected on one of the chains of tested soldered connections, and means for recording the location on the circuit of the component showing this fracture, and of the associated chain of soldered connections.

2. A device according to claim 1, **characterised in that** the adjustment means (24-29) make it possible to modify the threshold for detecting a level of electrical resistance in the circuit under test.

3. A device according to claim 2, **characterised in that** the adjustment means (24-29) include a potentiometer (24) to set the threshold for detecting the level of electrical resistance in the component (5) of the circuit (2) under test.

4. A device according to any one of claims 1 to 3, **characterised in that** the adjustment means (24-29) make it possible to modify the number of state changes in the circuit (2) under test to be detected in order to validate the criterion initially chosen by the user.

5. A device according to claim 4, **characterised in that** the adjustment means (24-29) include a selector (27) to determine a number of peaks to be detected for the application of the detection criterion.

6. A device according to any one of claims 1 to 5, **characterised in that** the adjustment means (24-29) make it possible to modify a time interval between two state change detections in the circuit (2) under test.

7. A device according to claim 6, **characterised in that** the adjustment means (24-29) include potentiometers (25, 26) to determine a time interval after a peak in order to detect a subsequent peak.

8. A device according to claim 6 or 7, **characterised in that** the minimum time interval between two detected state changes in a component (5) is 250 ns.

9. A device according to claims 1 to 8, **characterised in that** the duration of the electrical resistance peaks to be detected is adjustable between 250 ns and 1 µs.

10. A device according to claim 9, **characterised in that** the duration between the start of the test and the first detected peak in electrical resistance for the criterion chosen by the user is adjustable.

11. A device according to any one of claims 1 to 10, **characterised in that** the software portion (13) includes means (29) for recording and processing results in real time.

12. A device according to any one of claims 1 to 11, **characterised in that** the hardware portion (9) is integrated on a board outside of the enclosure (8).

13. A method for implementing a device (1) for testing a circuit (2) made up of a printed circuit board (3) on which components (4), preferably dummy components, are assembled by means of solder connections according to any one of claims 1 to 12, **characterised in that** it comprises the following operations:
- parameters are initialised for detecting damage in the solder connections,
- state changes are detected and recorded for the electrical resistance of one or more solder connections to be tested, which is **characterised by** peaks of electrical resistance with a duration between 250 ns and 1 µs,
- state changes are transmitted to the software portion to be analysed,
- it is determined whether a fracture was detected on one of the chains of soldered connections tested, and the location on the circuit of the component having this fracture, and the associated solder connection chain, are then recorded.
